# EUROPEAN PATENT SPECIFICATION

(11) **EP 3 229 570 B1**
(45) Date of publication and mention of the grant of the patent: **18.11.2020**
(21) Application number: 17152511.6
(22) Date of filing: 20.01.2017
(51) Int. Cl.: H05K 7/14, H05K 7/20

(54) **POWER CONVERSION DEVICE**
STROMWANDLUNGSVORRICHTUNG
DISPOSITIF DE CONVERSION D'ALIMENTATION ÉLECTRIQUE

(30) Priority: 30.03.2016 JP 2016067039
(43) Date of publication of application: 11.10.2017
(73) Proprietor: Hitachi, Ltd., Chiyoda-ku, Tokyo 100-8280 (JP)
(72) Inventor: Yasuda, Yosuke, Chiyoda-ku, Tokyo 100-8280 (JP); Katagiri, Masaru, Chiyoda-ku, Tokyo 100-8280 (JP); Mae, Kentarou, Chiyoda-ku, Tokyo 100-8280 (JP); Nishimura, Yoshitaka, Chiyoda-ku, Tokyo 100-8280 (JP); Yamauchi, Takahiro, Chiyoda-ku, Tokyo 100-8280 (JP)
(74) Representative: Mewburn Ellis LLP

(56) References cited:
- JP-A- 2009 015 869

## Description

### BACKGROUND OF THE INVENTION

The present invention relates particularly to a power conversion device which includes a system for cooling a semiconductor element converting power in a liquid cooling manner.

An electric motor vehicle such as a railway vehicle is provided with a control device for driving the vehicle which controls power to be supplied to a driving motor, and a power conversion device such as an auxiliary power source device which controls the power to be supplied to an onboard electric facility such as an air conditioner. In this power conversion device, there is provided a semiconductor element which switches the current to make conversion to DC/AC.

At the time of energizing and switching, heat loss occurs in the semiconductor element, and there is a concern about that the semiconductor element may be broken down when it comes to a high temperature. Therefore, the semiconductor element is necessarily cooled down to fall within a predetermined temperature range. A liquid cooling manner is employed as a cooling method of the semiconductor element. JP 2005-516570 A discloses a configuration of the power conversion device which employs the liquid cooling manner.

In JP 2005-516570 A, units such as a cooling unit and other electronic circuits of the power conversion device are mounted with a high density.

JP 2009-015869 A proposes a liquid-cooled electronic device.

### SUMMARY OF THE INVENTION

A railway vehicle requires a large-capacity power conversion circuit compared to an automobile. Therefore, considering an assembly performance and a maintenance performance, the power conversion circuit is configured by a plurality of power units, and assembling of the power units to a housing or disassembling for maintenance is preferably performed for each power unit. In addition, the power conversion device is mainly mounted in a restricted installation space of a floor of the railway vehicle. Therefore, the device is preferably miniaturized.

The invention is defined by the features of claim 1. Further embodiments are defined in the dependent claims.

The invention has been made to solve the above problems, and an object thereof is to provide a small-sized power conversion device in which the power unit is easily assembled or disassembled with respect to the housing.

A power conversion device according to the invention for achieving the above object is provided by claim 1.

The electric connector provided on a side near the housing may be connected to an electric connector provided on a side near the power unit by pushing the power unit using the pushing mechanism.

The electric connector provided on a side near the power unit may be kept in connection with an electric connector provided on a side near the housing by fastening the holding member and the housing using the fixing bolt.

The pushing mechanism may be provided in a side surface of the power conversion device.

The refrigerant pipe connector may be provided in a center portion of the power conversion device.

The electric connector may be provided in a center portion of the power conversion device.

The power conversion device may include a plurality of wirings through which power is input or output with respect to the power unit and a plurality of pipes which connect the power unit to the cooling device, and the plurality of wirings and the plurality of pipes may be gathered together in a space provided in the center portion of the power conversion device.

The power conversion device may be provided below a floor of a railway vehicle.

According to the invention, it is possible to provide a small-sized power conversion device which is easily assembled or disassembled with respect to a housing.

Other objects, features and advantages of the invention will become apparent from the following description of the embodiments of the invention taken in conjunction with the accompanying drawings.

### BRIEF DESCRIPTION OF THE DRAWINGS

FIG. 1 is a plan view illustrating a layout of components of a power conversion device according to a first embodiment of the invention;
FIG. 2 is a diagram illustrating a power unit which is mounted in the power conversion device according to the first embodiment of the invention when viewed from a direction of arrow A of FIG. 1;
FIG. 3 is a diagram illustrating a state where the power unit mounted in the power conversion device according to the first embodiment of the invention is assembled in a housing when viewed in a direction of arrow B of FIG. 2;
FIG. 4 is a diagram illustrating a state where the power unit mounted in the power conversion device according to the first embodiment of the invention is assembled to the housing when viewed in a direction of arrow B of FIG. 2;
FIG. 5 is a diagram illustrating a state where a power unit mounted in a power conversion device according to a second embodiment of the invention is assembled to the housing;
FIG. 6 is a plan view illustrating a configuration of a main circuit wire for motor driving of the power conversion device according to the second embodiment of the invention; and
FIG. 7 is a diagram illustrating a configuration in a case where the power conversion device according to the embodiment of the invention is mounted in a railway vehicle.

### DESCRIPTION OF THE EMBODIMENTS

Hereinafter, embodiments of the invention will be described with reference to the drawings.

### [First Embodiment]

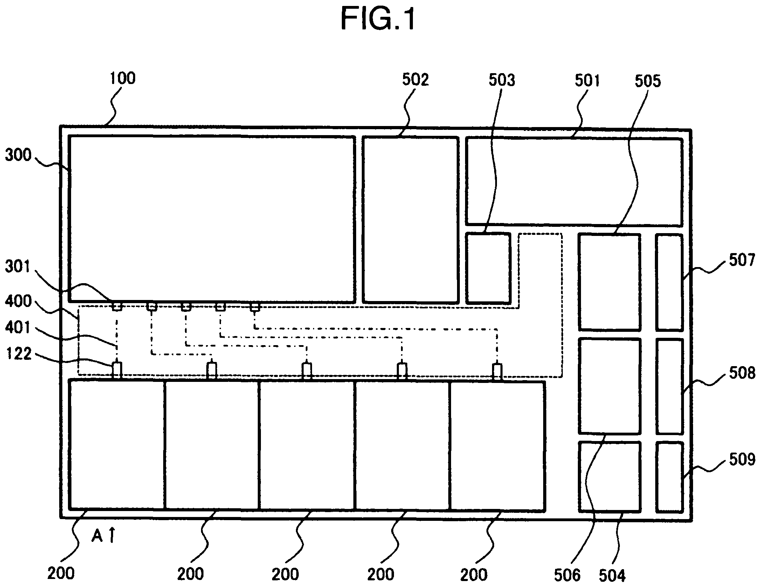

FIG. 1 is a plan view illustrating a layout of components of a power conversion device according to a first embodiment of the invention. The power conversion device includes a housing 100, five power units 200, each of which includes a power conversion circuit, a cooling device 300 which supplies a liquid refrigerant to the power unit 200, a control device 501 which controls power conversion of the power unit 200, an AC reactor 502 which smooths a three-phase alternating current output from the power unit, an AC capacitor 503 which smooths a three-phase alternating voltage output from the power unit, a contactor 504 which disconnects a current when a ground fault occurs, a motor output core 505 which eliminates three-phase AC noises of a motor output, an auxiliary power source output core 506 which eliminates three-phase AC noises of an auxiliary power source output, a motor output terminal 507, an auxiliary power source output terminal 508, and an input terminal 509. These components are provided on the side surfaces or the end portions of the housing 100. A center space 400 is provided in a portion surrounded by a dotted line in the center portion of the housing 100 illustrated in FIG. 1. A refrigerant pipe 401 is installed in the power unit 200 through a housing-side refrigerant pipe connector 122. The refrigerant pipe 401 is connected to a cooling-device-side refrigerant pipe connector 301 provided in the cooling device 300 through the center space 400, and forms a flow channel for circulating the liquid refrigerant. In FIG. 1, five refrigerant pipes 401 are illustrated which supply the refrigerant from the cooling device 300 to five power units 200. However, there are actually provided five refrigerant pipes for returning the liquid refrigerant from five power units 200 to the cooling device 300. Therefore, total ten refrigerant pipes 401 are provided, and the refrigerant pipe connectors 301 and 122 are also provided by "10" respectively. In addition, five power units 200 are configured to be individually detachably attached to the housing 100.

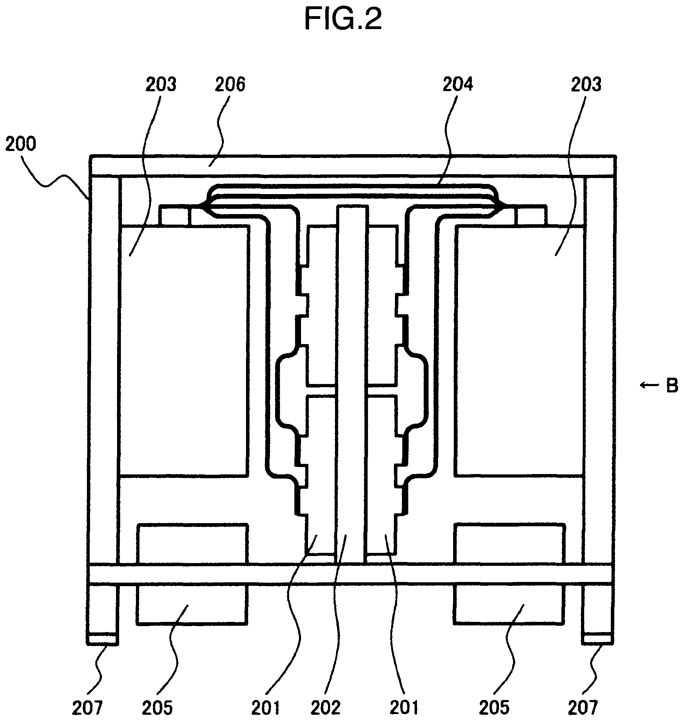

The configuration of the power unit 200 will be described. FIG. 2 is a diagram illustrating one power unit 200 mounted in the power conversion device according to the first embodiment of the invention when viewed in a direction of arrow A of FIG. 1. The power unit 200 is configured by a semiconductor element 201 which switches a current, a cooling plate 202 which includes the flow channel of the liquid refrigerant therein, a filter capacitor 203 which smooths a main circuit voltage, a bypass 204 which smooths a main circuit current, a gate driver 205 which outputs a switching signal to the semiconductor element 201, a frame 206 which holds the cooling plate 202, the filter capacitor 203, and the gate driver 205, and a slide plate 207 which is provided in the lower surface of the frame 206. A plurality of semiconductor elements 201 are installed in both surfaces of the cooling plate 202. The filter capacitor 203 is provided on both sides of the cooling plate 202 one by one, and electrically connected to the semiconductor element 201 by the bypass 204. The gate driver 205 is electrically connected to the semiconductor element 201 by a control wire (not illustrated in the drawing).

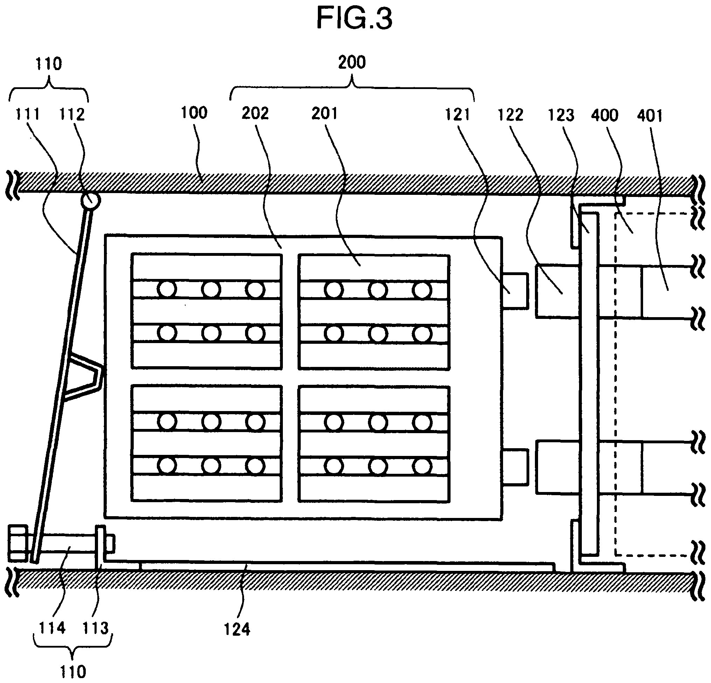

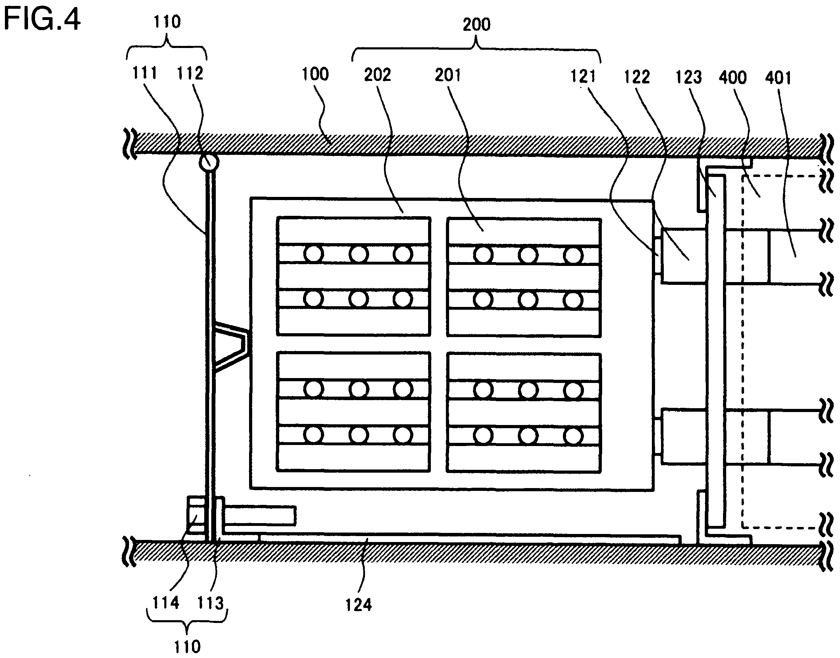

The description will be made about a state where the power unit 200 is mounted in the housing 100. FIG. 3 is a diagram illustrating a state before one power unit 200 mounted in the power conversion device according to the first embodiment of the invention is assembled in the housing 100 when viewed in a direction of arrow B of FIG. 2. In addition, FIG. 4 illustrates a state where the power unit 200 is assembled to the housing 100. In FIGS. 3 and 4, the filter capacitor 203, the bypass 204, the gate driver 205, the frame 206, and the slide plate 207 are omitted.

A pushing mechanism 110 for pushing the power unit 200 toward the center of the housing 100 is provided on a side surface of the housing 100 (the left side of FIG. 2). The pushing mechanism 110 is configured by a holding member 111, a hinge 112, an L-shape steel 113, and a fixing bolt 114. The holding member 111 has a convex center portion, and is configured to rotate about the hinge 112 provided in the upper portion of the housing. In addition, the L-shape steel 113 is provided in the lower portion of the housing 100, and a screw hole is provided to fasten the holding member 111 and the fixing bolt 114.

Two power-unit-side refrigerant pipe connectors 121 are provided toward the center space 400 of the housing 100 in the cooling plate 202. A refrigerant path is formed such that the refrigerant flows from one of the power-unit-side refrigerant pipe connectors 121, and flows out from the other one. In addition, two housing-side refrigerant pipe connectors 122 are provided in a state of being held to a housing-side fixing plate 123 on a side toward the center of the housing 100. The power-unit-side refrigerant pipe connector 121 pairs up with the housing-side refrigerant pipe connector 122, and there is provided a mechanism to keep the connection therebetween when a compression force is added. A side, with the housing-side fixing plate 123 interposed, opposite to the place where the housing-side refrigerant pipe connector 122 is connected to the power-unit-side refrigerant pipe connector 121 faces the center space 400, and is connected to the refrigerant pipe 401.

As illustrated in FIG. 3, a convex center portion of the holding member 111 is pressed to the cooling plate 202, and the fixing bolt 114 is fastened to the L-shape steel 113, so that the holding member 111 is pushed toward the center of the housing 100. Therefore, the power unit 200 comes to be pushed toward the center of the housing 100. As illustrated in FIG. 4, the power-unit-side refrigerant pipe connector 121 and the housing-side refrigerant pipe connector 122 are connected by tightly fastening the fixing bolt 114 to the L-shape steel 113. Further, the slide plate 207 provided in the lower portion of the frame 206 of the power unit 200 illustrated in FIG. 2 slides, the power unit 200 is pushed toward the center of the housing 100 while sliding on a rail 124 provided in the lower portion of the housing 100 illustrated in FIGS. 3 and 4 so as to be guided to connect the power-unit-side refrigerant pipe connector 121 to the housing-side refrigerant pipe connector 122.

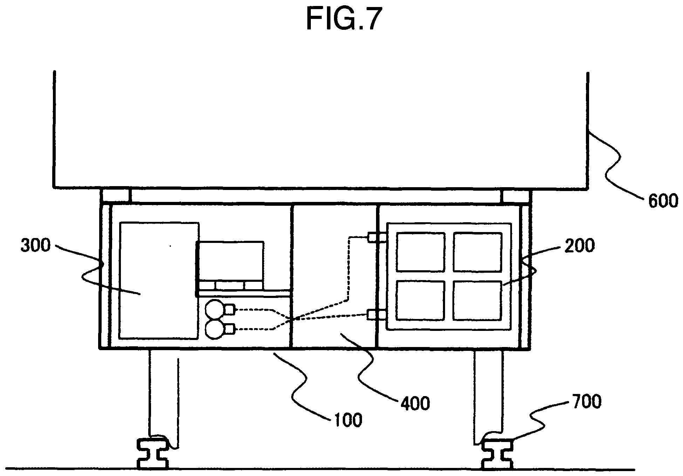

Next, a diagram of a configuration in a case where the power conversion device illustrated in FIGS. 1 to 4 is mounted in a railway vehicle is illustrated in FIG. 7. The power conversion device is mounted below a floor of a vehicle body 600 of the railway vehicle, the power units 200 are disposed in the side surface of the vehicle, and the respective power units 200 are detachably attached to the side surface. In addition, the refrigerant pipe 401 is provided in the center space 400 provided on a side near the center of the power unit 200.

The effect of the first embodiment will be described. When the power unit 200 is assembled to the housing, the power unit 200 is desirably assembled to the housing 100 from the side surface of the power conversion device. On the other hand, in a case where a power conversion capacity of the power conversion device is large, there is a need to increase a flow rate of the refrigerant in order to secure cooling performance. Further, there is a need to increase an inner diameter of the refrigerant pipe 401 in order to reduce a pressure loss in the refrigerant pipe 401. In a case where the power-unit-side refrigerant pipe connector 121 and the housing-side refrigerant pipe connector 122 are disposed in the side surface of the power conversion device, the refrigerant pipe 401 is necessarily extended from the cooling device 300 up to the side surface of the power conversion device. Therefore, the increase in the inner diameter of the refrigerant pipe 401 causes trouble in assembling the power unit 200 to the housing 100. As described in the invention, the power unit 200 is easily assembled or disassembled with respect to the housing 100 by disposing the power-unit-side refrigerant pipe connector 121 and the housing-side refrigerant pipe connector 122 on a side near the center of the power conversion device.

In addition, five power units 200 are provided in the power conversion device according to the first embodiment, and are configured to be individually detachably attached. With such a configuration, a unit weight for attaching/detaching the power unit 200 is lowered, so that the assembling or disassembling work of the power unit 200 with respect to the housing 100 becomes easy.

In addition, the pushing mechanism 110 is provided in the first embodiment to keep a state where the power unit 200 is pushed toward the side surface of the power conversion device. With such a configuration, a work of pushing and detaching the power unit 200 can be performed from the side surface of the power conversion device. Therefore, the power unit 200 is easily assembled or disassembled with respect to the housing 100.

Furthermore, when the power-unit-side refrigerant pipe connector 121 and the housing-side refrigerant pipe connector 122 are connected, it is necessary to apply a compression force as large as preventing a refrigerant leakage even in a vibrating environment. The holding member 111 of the pushing mechanism 110 rotates about the hinge 112 of the upper portion of the housing, and pushes the power unit 200 in which the fixing bolt 114 of the lower portion of the housing serves as a point of effort and the convex center portion of the holding member 111 serves as a point of action. With such a configuration, the power unit 200 can be simply pushed with a small axial force by a principle of leverage only by fastening the fixing bolt 114 (point of effort), so that the assembling work of the power unit 200 to the housing 100 becomes easy.

In addition, in a case where the power conversion device is configured by a plurality of power units 200, the number of refrigerant pipes 401 is increased. Therefore, a wide installation space is required. As described in the first embodiment, the power conversion device can be miniaturized by providing the center space 400 in the housing 100, and gathering the refrigerant pipes 401 in the center space 400.

In addition, when the power unit of the power conversion device provided in the floor of the railway vehicle is maintained, it is desirable to have a configuration that the power unit can be detached or assembled with respect to the side surface of the power conversion device. With the configuration of the first embodiment, it is possible to provide a power conversion device which has a small size suitable for the installation in the floor of the railway vehicle and is easily maintained.

Further, the holding member 111 may be configured to be detached from the hinge 112. With the detachable configuration, a work is not hindered when the power unit 200 is inserted to the housing 100 up to the state illustrated in FIG. 3, or when the power unit 200 is detached toward the outside of the housing 100 from the state illustrated in FIG. 3. Therefore, the power unit 200 is easily assembled or detached with respect to the housing 100.

### [Second Embodiment]

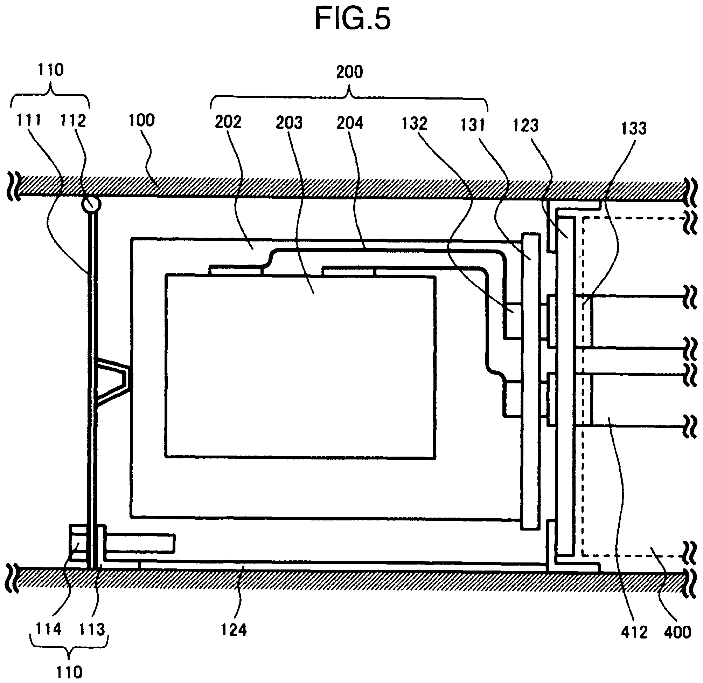

FIG. 5 is a diagram illustrating a state when a power unit mounted in a power conversion device according to a second embodiment of the invention is mounted in the housing. In FIG. 5, the gate driver 205, the frame 206, and the slide plate 207 are omitted. In the second embodiment, a power-unit-side fixing plate 131 is installed on a side near the center of the cooling plate 202, and a power-unit-side electric connector 132 is provided in a state of being held to the power-unit-side fixing plate 131. The filter capacitor 203 is electrically connected to the power-unit-side electric connector 132 through the bypass 204. In addition, in the center of the housing 100, a housing-side electric connector 133 is provided in a state of being held to the housing-side fixing plate 123. The power-unit-side electric connector 132 pairs up with the housing-side electric connector 133, and the power-unit-side electric connector 132 and the housing-side electric connector 133 are connected by pushing the power unit 200 to the housing 100 using the pushing mechanism 110. A side opposite to the place where the housing-side electric connector 133 is connected to the power-unit-side electric connector 132 faces the center space 400, and connected to a DC wire 412.

As described in the second embodiment, not only the refrigerant connector but also the electric connector can be configured to be pressed and connected with a high compression force by pushing the power unit 200 to the housing 100 using the pushing mechanism 110. Therefore, the electrical connection can be prevented from being released even in a vibrating environment, and the power unit 200 can be easily assembled or disassembled with respect to the housing 100.

Further, FIG. 5 illustrates a state where the power unit 200 and the DC wire 412 are connected for example, but the invention is not limited thereto and can be applied to the connection of a single-phase AC wire 411 and a three-phase AC wire 413 described below.

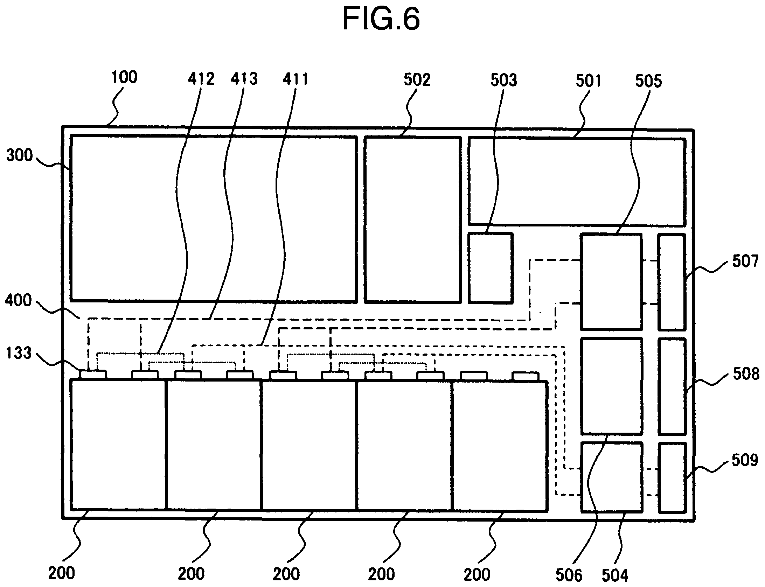

In addition, FIG. 6 is a plan view illustrating a configuration of a main circuit wire for motor driving of the power conversion device according to the second embodiment of the invention. The broken line 411 in the drawing indicates the single-phase AC wire, the dotted line 412 indicates the DC wire, and the long broken line 413 indicates the three-phase AC wire. The single-phase AC wire 411 is connected from the input terminal 509 to the power unit 200 through a contactor 504. The power units 200 are connected by the DC wire 412 by every two units. The three-phase AC wire 413 serving as the output of the power unit 200 is connected to the motor output terminal 507 through the motor output core 505. The single-phase AC wire 411, the DC wire 412, and the three-phase AC wire 413 are gathered together in the center space 400.

In a case where the power conversion capacity of the power conversion device is large and the power conversion device is configured by the plurality of power units 200, the diameters of the wires are enlarged, and the number of wires is increased. As described in the second embodiment, it is possible to miniaturize the power conversion device by gathering the single-phase AC wire 411, the DC wire 412, and the three-phase AC wire 413 together in the center space 400 of the housing 100.

## Claims

1. A power conversion device comprising:
a housing (100);
a plurality of power units (200) mounted in the housing (100) and each including a power conversion circuit; and
a cooling device (300) that is mounted in the housing (100) and is adapted to cool down the plurality of power units (200) using a liquid refrigerant,
wherein the plurality of power units (200) are configured to be detachably attached to the housing (100) one by one;
**characterized in that**:
the housing (100) includes, for each power unit (200), a respective pushing mechanism (110) comprising a holding member (111) for applying a force to the power unit (200), a hinge (112) connecting an end of the holding member (111) to an upper portion of the housing (100), a screw hole provided on an L-shape steel (113) in the lower portion of the housing (100), and a fixing bolt (114) configured for fastening an opposite end of the holding member (111) to the screw hole, the pushing mechanism (110) being adapted such that turning the fixing bolt (114) in the screw hole rotates the holding member (111) about the hinge to push the holding member (111) to the power unit (200), whereby a power-unit-side refrigerant pipe connector (121) is kept in connection with a housing-side refrigerant pipe connector (122).

2. The power conversion device according to claim 1,
wherein a power-unit-side electric connector (132) is kept in connection with a housing-side electric connector (133) by fastening the holding member (111) and the housing (100) using the fixing bolt (114).

3. The power conversion device according to claim 1 or 2,
wherein the pushing mechanism (110) is provided in a side surface of the power conversion device.

4. The power conversion device according to any one of claims 1 to 3,
wherein the refrigerant pipe connectors (121, 122) are provided in a center portion of the power conversion device.

5. The power conversion device according to any one of claims 1 to 4,
wherein the electric connectors (132, 133) are provided in a center portion of the power conversion device.

6. The power conversion device according to any one of claims 1 to 5,
wherein the power conversion device further comprises a plurality of wirings through which power is input or output with respect to the power unit (200), and a plurality of pipes that connect the power unit (200) to the cooling device (300), and
the plurality of wirings and the plurality of pipes are gathered together in a center portion of the power conversion device.

7. The power conversion device according to any one of claims 1 to 6,
wherein the power conversion device is provided below a floor of a railway vehicle.

## Patentansprüche

1. Leistungswandlervorrichtung, die Folgendes umfasst:
ein Gehäuse (100);
eine Vielzahl von Leistungseinheiten (200), die in dem Gehäuse (100) befestigt sind und jeweils eine Leistungswandlerschaltung umfassen; und
eine Kühlvorrichtung (300), die in dem Gehäuse (100) befestigt ist und geeignet ist, um die Vielzahl von Leistungseinheiten (200) unter Verwendung eines flüssigen Kühlmittels abzukühlen,
wobei die Vielzahl von Leistungseinheiten (200) ausgelegt ist, um einzeln abnehmbar an dem Gehäuse (100) angebracht zu sein;
**dadurch gekennzeichnet, dass**
das Gehäuse (100) Folgendes umfasst: für jede Leistungseinheit (200) einen entsprechenden Drückmechanismus (110), der ein Halteelement (111) zum Ausüben einer Kraft auf die Leistungseinheit (200), ein Scharnier (112), das ein Ende des Halteelements (111) mit einem oberen Abschnitt des Gehäuses (100) verbindet, ein Schraubloch, das auf einem L-förmigen Stahl (113) im unteren Abschnitt des Gehäuses bereitgestellt ist, und eine Befestigungsschraube (114), die ausgelegt ist, um ein entgegengesetztes Ende des Halteelements (111) an dem Schraubloch zu fixieren, wobei der Drückmechanismus (110) so angepasst ist, dass das Drehen der Befestigungsschraube (114) in dem Schraubloch das Halteelement (111) um das Scharnier dreht, um das Halteelement (111) in Richtung der Leistungseinheit (200) zu drücken, wodurch ein leistungseinheitseitiges Kühlmittelleitungsverbindungsstück (121) mit einem gehäuseseitigen Kühlmittelleitungsverbindungsstück (122) in Verbindung gehalten ist.

2. Leistungswandlervorrichtung nach Anspruch 1,
wobei ein leistungseinheitseitiges elektrisches Verbindungsstück (132) mit einem gehäuseseitigen elektrischen Verbindungsstück (133) in Verbindung gehalten ist, indem das Halteelement (111) und das Gehäuse (100) mittels des Befestigungsbolzens (114) fixiert sind.

3. Leistungswandlervorrichtung nach Anspruch 1 oder 2,
wobei der Drückmechanismus (110) in einer Seitenoberfläche der Leistungswandlervorrichtung bereitgestellt ist.

4. Leistungswandlervorrichtung nach einem der Ansprüche 1 bis 3,
wobei die Kühlmittelleitungsverbindungsstücke (121, 122) in einem zentralen Abschnitt der Leistungswandlervorrichtung bereitgestellt sind.

5. Leistungswandlervorrichtung nach einem der Ansprüche 1 bis 4,
wobei die elektrischen Verbindungsstücke (132, 133) in einem zentralen Abschnitt der Leistungswandlervorrichtung bereitgestellt sind.

6. Leistungswandlervorrichtung nach einem der Ansprüche 1 bis 5,
wobei die Leistungswandlervorrichtung ferner Folgendes umfasst: eine Vielzahl von Verdrahtungen, durch die Leistung in Bezug auf die Leistungseinheit (200) eingespeist oder ausgegeben wird, und eine Vielzahl von Leitungen, die die Leistungseinheit (200) mit der Kühlvorrichtung (300) verbinden, und
wobei die Vielzahl von Verdrahtungen und die Vielzahl von Leitungen in einem zentralen Abschnitt der Leistungswandlervorrichtung zusammengefasst sind.

7. Leistungswandlervorrichtung nach einem der Ansprüche 1 bis 6,
wobei die Leistungswandlervorrichtung unter einem Boden eines Schienenfahrzeugs bereitgestellt ist.

## Revendications

1. Dispositif de conversion de puissance comprenant :
un boîtier (100) ;
une pluralité d'unités de puissance (200) montées dans le boîtier (100) et comprenant chacune un circuit de conversion de puissance ; et
un dispositif de refroidissement (300) qui est monté dans le boîtier (100) et est adapté pour refroidir la pluralité d'unités de puissance (200) en utilisant un réfrigérant liquide,
dans lequel la pluralité d'unités de puissance (200) sont configurées pour être fixées de manière amovible au boîtier (100) une par une ;
**caractérisé en ce que** :
le boîtier (100) comprend, pour chaque unité de puissance (200), un mécanisme de poussée respectif (110) comprenant un élément de maintien (111) pour appliquer une force à l'unité de puissance (200), une articulation (112) reliant une extrémité de l'élément de maintien (111) à une partie supérieure du boîtier (100), un trou de vis prévu sur un acier en forme de L (113) dans la partie inférieure du boîtier (100), et un boulon de fixation (114) configuré pour fixer une extrémité opposée de l'élément de maintien (111) au trou de vis, le mécanisme de poussée (110) étant adapté de telle sorte qu'une rotation du boulon de fixation (114) dans le trou de vis fait tourner l'élément de maintien (111) autour de l'articulation pour pousser l'élément de maintien (111) vers l'unité de puissance (200), de sorte qu'un connecteur de tuyau de réfrigérant côté unité de puissance (121) est maintenu en connexion avec un connecteur de tuyau de réfrigérant côté boîtier (122).

2. Dispositif de conversion de puissance selon la revendication 1,
dans lequel un connecteur électrique côté unité de puissance (132) est maintenu en connexion avec un connecteur électrique côté boîtier (133) en fixant l'élément de maintien (111) et le boîtier (100) à l'aide du boulon de fixation (114).

3. Dispositif de conversion de puissance selon la revendication 1 ou 2,
dans lequel le mécanisme de poussée (110) est prévu dans une surface latérale du dispositif de conversion de puissance.

4. Dispositif de conversion de puissance selon l'une quelconque des revendications 1 à 3,
dans lequel les connecteurs de tuyau de réfrigérant (121, 122) sont prévus dans une partie centrale du dispositif de conversion de puissance.

5. Dispositif de conversion de puissance selon l'une quelconque des revendications 1 à 4,
dans lequel les connecteurs électriques (132, 133) sont prévus dans une partie centrale du dispositif de conversion de puissance.

6. Dispositif de conversion de puissance selon l'une quelconque des revendications 1 à 5,
dans lequel le dispositif de conversion de puissance comprend en outre une pluralité de câblages à travers lesquels de la puissance est entrée ou délivrée en sortie par rapport à l'unité de puissance (200), et une pluralité de tuyaux qui relient l'unité de puissance (200) au dispositif de refroidissement (300), et
la pluralité de câblages et la pluralité de tuyaux sont rassemblés ensemble dans une partie centrale du dispositif de conversion de puissance.

7. Dispositif de conversion de puissance selon l'une quelconque des revendications 1 à 6,
dans lequel le dispositif de conversion de puissance est prévu sous un plancher d'un véhicule ferroviaire.
